# EUROPÄISCHE PATENTSCHRIFT

(11) **EP 0 933 807 B1**
(45) Veröffentlichungstag und Bekanntmachung des Hinweises auf die Patenterteilung: **14.06.2006**
(21) Anmeldenummer: 98124404.9
(22) Anmeldetag: 21.12.1998
(51) Int. Cl.: H01L 21/331, H01L 21/332

(54) **Verfahren zur Herstellung eines Leistungshalbleiterbauelementes**
Method for manufacturing a power semiconductor device
Procédé de fabrication d'un dispositif semi-conducteur de puissance

(30) Priorität: 03.02.1998 DE 19804192
(43) Veröffentlichungstag der Anmeldung: 04.08.1999
(73) Patentinhaber: Infineon Technologies AG, 81669 München (DE)
(72) Erfinder: Reznik, Daniel, Dr., 80686 München (DE); Schulze, Hans-Joachim, Dr., 85521 Ottobrunn (DE); Wolfgang, Eckhard, 31379 München (DE)
(74) Vertreter: Patentanwälte Westphal, Mussgnug & Partner

(56) Entgegenhaltungen:
- US-A- 5 608 237
- PATENT ABSTRACTS OF JAPAN vol. 13, no. 404 (E-817), 7. September 1989 (1989-09-07) & JP 01 145860 A (YAZAKI CORP), 7. Juni 1989 (1989-06-07)
- T. OGURA ET LA.: "High frequency 6000 V double gate GTOs with buried gate structure" PROCEEDINGS OF 1990 INTERNATIONAL SYMPOSIUM ON POWER SWMICONDUCTOR DEVICES & ICS,1990, Seiten 252-255, XP002123881 tokyo, japan

## Beschreibung

Die vorliegende Erfindung betrifft ein Verfahren zur Herstellung von Leistungshalbleiterbauelementen mit einer Strukturierung an zwei einander gegenüberliegenden Oberseiten, insbesondere von bidirektionalen Halbleiterschaltern.

In der Veröffentlichung von T. Ogura e. a.: "High frequency 6000 V double gate GTOs with buried gate structure" in Proceedings of 1990 International Symposium on Power Semiconductor Devices & ICs, Seiten 252 - 255, ist eine Bauelementstruktur beschrieben, bei der zur Ausbildung eines GTO-Thyristors auf zwei einander gegenüberliegenden Oberseiten eines Substrates Halbleiterstege mit dotierten Bereichen und Kontaktierungen ausgebildet sind. In der US 5,608,237 ist ein bidirektionaler Halbleiterschalter beschrieben, bei dem IGBT-Strukturen an zwei einander gegenüberliegenden Oberseiten eines Substrates aus Halbleitermaterial ausgebildet sind. Ein derartiger bidirektionaler IGBT ermöglicht durch die zusätzliche Steuerelektrode die Steuerung der Emittereffizienz, und es kann auf diese Weise ein Bauelement mit sehr guten Schalt- und Durchlaßeigenschaften realisiert werden. In Umrichtern (Transformatoren), die einen sinusförmigen Netzstrom bei geringer Rückwirkung ins Netz und gleichzeitiger Möglichkeit einer Rückspeisung ins Netz verarbeiten sollen, sind bidirektionale IGBTs vorteilhaft einsetzbar. Ein dafür geeigneter Matrix-Umrichter umfaßt neun bidirektionale Schalter, die durch achtzehn symmetrisch sperrende IGBTs, die paarweise antiparallel geschaltet sind, ersetzt sein können. Eine einfache Realisierung der in der US 5,608,237 beschriebenen Bauelemente bietet hier erhebliche Vorteile.

Die englischsprachige Zusammenfassung des Dokuments JP-A-01 145 860 offenbart ein Verfahren zur Herstellung eines Halbleiterbauelements, bei dem
in einem ersten Schritt an jeweils einer Oberseite zweier Substrate aus elektrisch leitend dotiertem Halbleitermaterial eine Struktur dotierter Bereiche hergestellt wird, in einem zweiten Schritt die gegenüberliegenden Oberseiten der Substrate gereinigt werden und
in einem dritten Schritt diese Oberseiten dauerhaft miteinander verbunden werden, wobei an der Verbindungsfläche ein pn-Übergang entsteht.

Aufgabe der vorliegenden Erfindung ist es, ein Verfahren zur Herstellung eines Leistungshalbleiterbauelementes anzugeben, das einfach durchführbar ist und das auch für die Herstellung komplizierter Halbleiterstrukturen auf zwei einander gegenüberliegenden Oberseiten eines dünnen Substrates geeignet ist.

Diese Aufgabe wird mit dem Verfahren mit den Merkmalen des Anspruches 1 gelöst. Ausgestaltungen ergeben sich aus den abhängigen Ansprüchen.

Bei dem erfindungsgemäßen Herstellungsverfahren werden für jedes Bauelement zwei Substrate aus Halbleitermaterial, das mit einer Grunddotierung für elektrische Leitfähigkeit versehen ist, verwendet. An jeweils einer Oberseite dieser Substrate werden durch übliche Verfahrensschritte des Dotierens elektrisch leitende Bereiche einer für das Bauelement vorgesehenen Struktur hergestellt. Es können auf diese Bereiche auch weitere Halbleiterschichten epitaktisch aufgewachsen werden und darauf Kontakte aufgebracht werden. Nachdem die Halbleiterstruktur in jedem Substrat fertiggestellt ist oder zumindest soweit fertiggestellt ist, daß es möglich ist, das Bauelement von beiden Seiten her weiter zu behandeln, werden die Substrate von der unstrukturierten Rückseite her gedünnt. Das kann z. B. durch Abschleifen oder Rückätzen geschehen. Die Rückseiten der gedünnten Substrate werden dann, vorzugsweise mittels des Verfahrens des Wafer-Bonding, dauerhaft und elektrisch leitend miteinander verbunden. Wegen der vorhandenen Grunddotierung ist damit eine elektrisch leitende Verbindung zwischen den Strukturen der beiden Oberseiten hergestellt. So kann insbesondere ein zu einer Mittelebene des Substrates spiegelsymmetrisch aufgebautes Bauelement auf einfache Weise hergestellt werden. Insbesondere lassen sich so bidirektionale Halbleiterschalter herstellen.

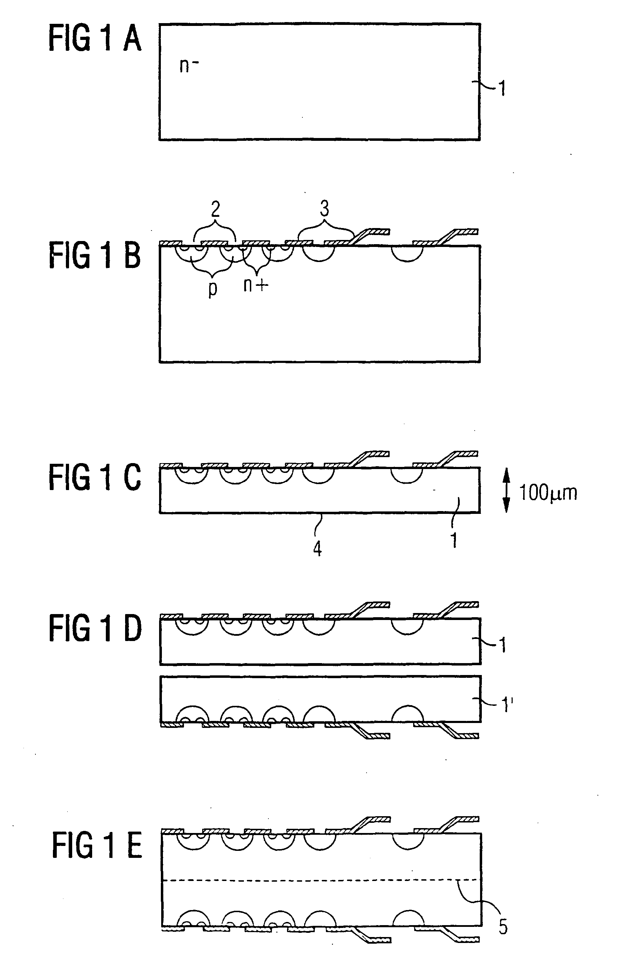

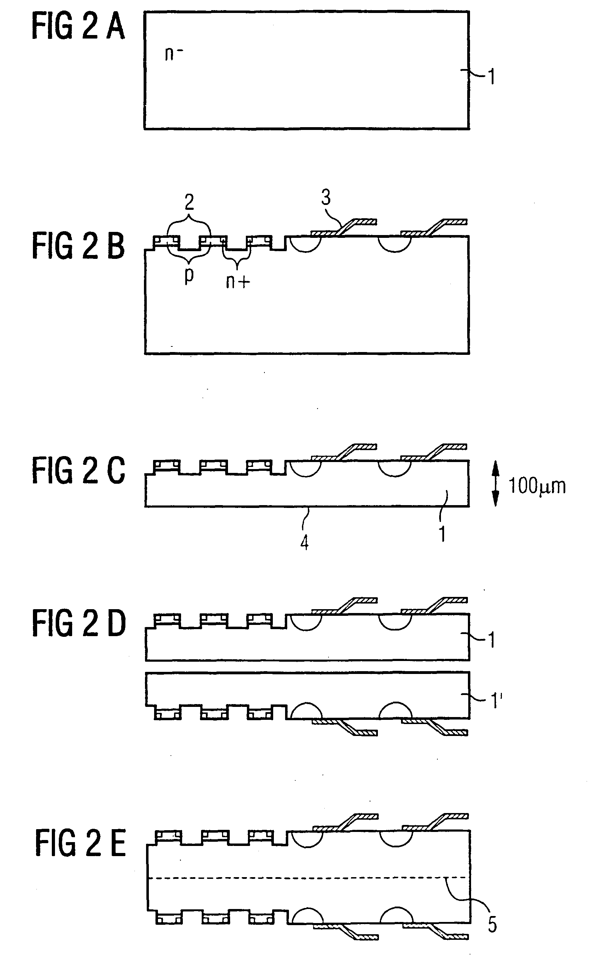

Es folgt eine genauere Beschreibung des erfindungsgemäßen Verfahrens anhand der Figuren 1 und 2, die ein Bauelement im Querschnitt nach verschiedenen Schritten des Herstellungsprozesses für zwei verschiedene IGBT-Strukturen zeigen.

Das erfindungsgemäße Verfahren geht jeweils aus von einem normal dicken Substrat 1 (Figur la bzw. Figur 2a), das mit einer, vorzugsweise niedrigen, Grunddotierung für elektrische Leitfähigkeit, in dem dargestellten Beispiel n⁻-Leitung, versehen ist. An einer Oberseite des Substrates wird die vorgesehene Bauelementstruktur hergestellt. In den dargestellten Beispielen der Figuren 1b and 2b handelt es sich um IGBT-Strukturen 2 mit darauf aufgebrachten Anschlußkontakten 3. In dem Ausführungsbeispiel der Figur 1 werden IGBTs in DMOS-Zellen-Technologie hergestellt; in dem Ausführungsbeispiel der Figur 2 werden IGBTs, die durch Gräben voneinander getrennt sind, (trench technology) hergestellt.

In einem nächsten Verfahrensschritt gemäß den Figuren 1c und 2c wird das Substrat 1 von der Rückseite 4 her gedünnt, was z. B. durch Abschleifen oder Ätzen geschehen kann. Im Beispiel eines 1200V-IGBT verbleibt eine Restdicke des Substrates von etwa 100 µm, bei einem 1700V-IGBT eine Restdicke von etwa 140 µm. Die abgeschliffenen Rückseiten werden nach Bedarf poliert, so daß sie ausreichend glatt für einen nachfolgenden Prozeß des Wafer-Bonding sind.

Ein in ähnlicher Weise vorbehandeltes zweites Substrat 1' (Figur 1d bzw. Figur 2d) wird mit seiner Rückseite dauerhaft an der Rückseite des ersten Substrates 1 befestigt. Die Substrate werden dazu z. B. unter Reinraumbedingungen gegeneinandergedrückt und bei geeigneten und für die betreffenden Materialien bekannten Druck- und Temperaturbedingungen gelagert. Wesentlich ist dabei, daß es möglich ist, die Verbindung der Substrate bei vergleichsweise niedrigen Temperaturen von unterhalb etwa 300 °C bis 400 °c (typische obere Grenze 350 °C) herbeizuführen, ohne die bereits hergestellten Halbleiterstrukturen zu beschädigen. Dadurch werden die dotierten Halbleiterscheiben elektrisch leitend dauerhaft miteinander verbunden, so daß ein Bauelement der gewünschten Abmessung Basisdicke, entsteht, das an zwei einander gegenüberliegenden Oberseiten eine vorgesehene Strukturierung aufweist. Es entsteht so das Bauelement entsprechend den Beispielen der Figuren le bzw. 2e, in denen die Verbindungsfläche 5 der ursprünglichen Substrate mit einer dünnen gepunkteten Linie angedeutet ist.

Mit diesem Verfahren können Leistungshalbleiterbauelemente mit beidseitiger Strukturierung und mit einer vergleichsweise geringen Dicke des mit der Grunddotierung versehenen Basisbereichs hergestellt werden, die für Anwendungen in bestimmten Bereichen der Betriebsparameter geeignet sind. Insbesondere können bzgl. der Verbindungsfläche 5 spiegelsymmetrische Bauelemente und bidirektionale Halbleiterschalter hergestellt werden. Es ist möglich, in den beiden miteinander zu verbindenden Substraten unterschiedliche Strukturierungen oder unterschiedliche Dotierungen herzustellen, wie das z. B. im Fall des GTO-Thyristors der eingangs zitierten Veröffentlichung erwünscht ist. Die Vorteile des Verfahrens liegen in der Tatsache, daß die Bauelemente bis zum Dünnschleifen in einem Standardprozeß hergestellt werden können, so daß der zusätzliche Aufwand gegenüber bekannten Verfahren gering gehalten werden kann. Das Dünnschleifen der Substrate kann so durchgeführt werden, daß die Restdicke der Substrate die vorgesehene Basisdicke liefert, die der gewünschten Spannungsklasse des Bauelementes entspricht und die sehr viel geringer sein kann als bei beidseitig strukturierten Leistungshalbleiterbauelementen, die nach herkömmlichen Verfahren hergestellt werden.

## Patentansprüche

1. Verfahren zur Herstellung eines Leistungshalbleiterbauelements, bei dem ;
- in einem ersten Schritt an jeweils einer Oberseite zweier Substrate (1) aus elektrisch leitend dotiertem Halbleitermaterial eine Struktur dotierter Bereiche (2) hergestellt wird,
- in einem zweiten Schritt die Substrate von einer gegenüberliegenden Oberseite her gedünnt werden und
- in einem dritten Schritt diese Oberseiten dauerhaft und elektrisch leitend miteinander verbunden werden.

2. Verfahren nach Anspruch 1, bei dem der dritte Schritt mittels Wafer-Bonding ausgeführt wird.

3. Verfahren nach Anspruch 2, bei dem der dritte Schritt bei Temperaturen unterhalb 350 °C durchgeführt wird.

4. Verfahren nach einem der Ansprüche 1 bis 3, bei dem in dem ersten Schritt Strukturen je eines oder mehrerer IGBT hergestellt werden.

5. Verfahren nach einem der Ansprüche 1 bis 3, bei dem in dem ersten Schritt Strukturen je eines oder mehrerer GTO-Thyristoren hergestellt werden.

## Claims

1. Method for producing a power semiconductor device, in which
- in a first step, a structure of doped regions (2) is produced at a respective top side of two substrates (1) made of electrically conductively doped semiconductor material,
- in a second step, the substrates are thinned from an opposite top side, and
- in a third step, these top sides are permanently and electrically conductively connected to one another.

2. Method according to Claim 1, in which the third step is performed by means of wafer bonding.

3. Method according to Claim 2, in which the third step is carried out at temperatures of below 350°C.

4. Method according to one of Claims 1 to 3, in which structures of in each case one or a plurality of IGBTs are produced in the first step.

5. Method according to one of Claims 1 to 3, in which structures of in each case one or a plurality of GTO thyristors are produced in the first step.

## Revendications

1. Procédé de fabrication d'un composant semi-conducteur de puissance, selon lequel
- dans une première étape, on produit une structure de zones dopées (2) chaque fois sur une face supérieure de deux substrats (1) en matériau semi-conducteur à dopage électro-conducteur,
- dans une deuxième étape, on amincit les substrats à partir d'une face supérieure opposée, et
- dans une troisième étape, on assemble ces faces supérieures l'une avec l'autre, de façon durable et électro-conductrice.

2. Procédé selon la revendication 1, selon lequel
on exécute la troisième étape par jonction sur plaquette.

3. Procédé selon la revendication 2, dans lequel
on exécute la troisième étape à des températures inférieures à 350°C.

4. Procédé selon l'une quelconque des revendications 1 à 3, selon lequel on produit, dans la première étape, des structures d'un ou de plusieurs transistors bipolaires à porte isolée (IGBT).

5. Procédé selon l'une quelconque des revendications 1 à 3, selon lequel on produit, dans la première étape, des structures d'un ou de plusieurs thyristors interrupteurs (GTO).
